# EUROPEAN PATENT SPECIFICATION

(11) **EP 0 542 460 B1**
(45) Date of publication and mention of the grant of the patent: **02.07.1997**
(21) Application number: 92310050.7
(22) Date of filing: 03.11.1992
(51) Int. Cl.: H03K 17/16, H03K 17/04, H03K 17/56

(54) **Reverse-bias control circuit for a voltage-drive switching element**
Steuerschaltung mit inverser Vorspannung für ein spannungsgesteuertes Schaltelement
Circuit de commande d'inversion de polarisation pour un élément de commutation à commande en tension

(30) Priority: 07.11.1991 JP 290266/91
(43) Date of publication of application: 19.05.1993
(73) Proprietor: FUJI ELECTRIC CO. LTD., Kawasaki 210 (JP)
(72) Inventor: Miyasaka, Tadashi, Matsumoto-shi, Nagano 390 (JP)
(74) Representative: Carmichael, David Andrew Halliday

(56) References cited:
- EP-A- 0 389 154
- EP-A- 0 420 582
- WO-A-91/09467

## Description

The present invention relates to the configuration of a reverse-bias control circuit disposed to block a surge voltage generated by the turning-off of a voltage-driven switching element such as a power metal-oxide-semiconductor field-effect transistor (MOSFET), or an insulated gate bipolar-mode transistor (IGBT) used as a high-speed switching element of inverters which control motors, for example in machine tools, robots, and air conditioning devices, or uninterruptible power systems for office automation devices and medical equipment.

There is known from EP-A-0420582 a reverse-bias control circuit for a voltage-driven switching element, which turns on upon receiving a forward-bias voltage across its gate and emitter, and turns off on a reverse-bias voltage, the known circuit being equipped with a voltage stepping-down circuit which operates in a time delay and a recovering circuit that issues signals to stop the operation of said stepping-down circuit.

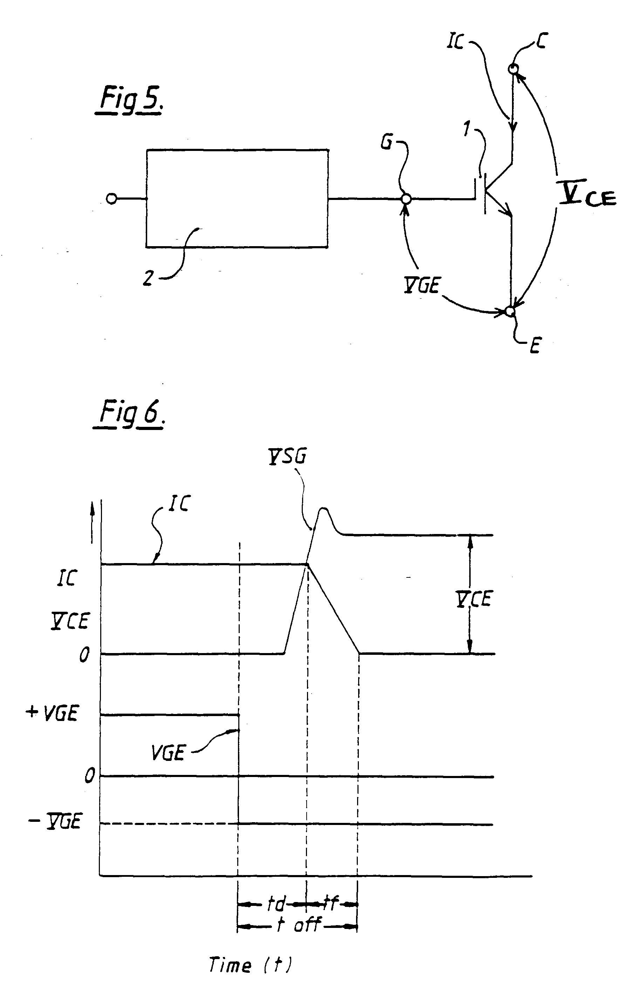

Figure 5 of the accompanying drawings is a circuit diagram for a conventional switching circuit with the voltage-driven switching element of which is modelled on an IGBT, and Figure 6 is a time chart showing the turn-off operations in a conventional switching circuit. In the Figures, when the IGBT 1 as a voltage-driven switching element is to be switched by applying the output bias-voltage V_{GE} from the drive circuit 2 to between the gate terminal G and the emitter terminal E of the IGBT, it is known that the speed of the turn-off operation can be increased by dropping the turn-off time t_{off} to 1 µs or less; for example, by changing the bias voltage V_{GE} stepwise from the forward-bias voltage +V_{GE} to -V_{GE}. Moreover, during the turn-off operation a malfunction resulting from so-called single transistor noise can be prevented.

However, the rate of change (di/dt) of the collector current I_{C} during the turn-off operation has become so great that a surge voltage V_{SG} is generated by superimposition on the wave front of the voltage V_{CE} between collector C and the emitter E in the IGBT as a result of the resonance of this current change with the main circuit inductance inside the module or the inductance in the external module connecting wire, whereas a surge-voltage exceeding the element withstand voltage in the IGBT can give rise to a problem because of an element breakdown failure.

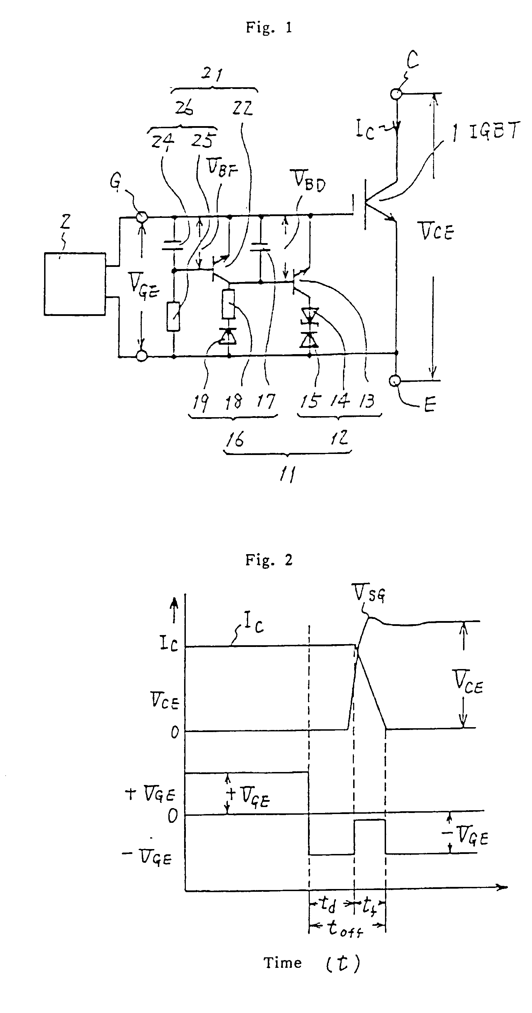

It is known that the di/dt characteristics of a voltage-driven switching element, or an IGBT, for example, have a reverse-bias voltage dependence, and that the di/dt can be reduced by decreasing (stepping-down) the reverse-bias voltage V_{GE}. However, simply decreasing the reverse-bias voltage creates a problem in that the turn-off delay time, t_{d}, (see Figure 2) increases, as does the generation loss, resulting in a narrower region for safe reverse-bias operation. Moreover, it is inconvenient, in that the dead zone time to prevent short circuits from above and below must be increased when two IGBTs are connected in series in an inverter circuit, since the response characteristics of the device are impaired.

The present invention is intended to obtain a reverse-bias control circuit that can step-down the reverse-bias voltage without increasing the turn-off delay time, thus blocking disturbances from surge-voltage and resulting in an increased speed in turning a voltage-driven switching element off.

In order to solve the above problems, according to the present invention, there is provided a reverse-bias control circuit for a voltage-driven switching element which turns on upon receiving a forward-bias voltage across its gate and emitter or across the gate and source, and turns off on a reverse-bias voltage, wherein the circuit is equipped with a voltage stepping-down circuit which operates after a time delay corresponding to the delay in turning off said voltage-driven switching element upon receiving the reverse-bias voltage, and a recovering circuit that issues signals to stop the operation of said stepping-down circuit at the end of the turn-off time of said voltage-driven switching element corresponding to the sum of said turn-off delay time and the fall time, characterised by the fact that the voltage stepping-down circuit consists of a voltage stepping-down section and a turn-off delay setting timer, wherein the stepping-down section consists of a series circuit with a first transistor, a Zener diode, and a first reverse blocking diode in which the emitter of the first transistor is connected to the gate of the voltage-driven switching element and both ends of said series circuit receive the reverse-bias voltage, the turn-off delay setting timer consists of a first resistance and a first capacitor connected in series with each other and in parallel with the voltage stepping-down section, and the base of said first transistor is connected to the turn-off delay setting timer at a point between the first resistance and the first capacitor, and wherein the recovering circuit consists of a second transistor and a turn-off setting timer, the second transistor forming a series circuit with said first resistance (18) and a second reverse blocking diode (19) and being connected in parallel to the first capacitor, with its emitter connected to the gate of the voltage-driven switching element, and the turn-off setting timer consisting of a second resistance and a second capacitor in series connection, between which the base of said second transistor is connected, the arrangement being such that the reverse-bias voltage is applied across the ends of the turn-off setting timer.

In addition, a respective one of the first and second reverse blocking diodes may be connected in series with the emitter side of each of the first and second transistors, in a direction that blocks a forward-bias current.

Furthermore, the reverse-bias control circuit constructed according to each of the above paragraphs is preferably mounted near the voltage-driven switching element in a single chip, and is modularised and formed as semiconductor devices, which are wire-bonded with each other.

In the construction of the present invention, because the circuit is equipped with a voltage stepping-down circuit which operates in a time-delay sequence corresponding to the delay in turning off the voltage-driven switching element upon receiving the reverse-bias voltage to decrease the reverse-bias voltage to the predetermined level during the time corresponding to the fall time of the flowing current, and a recovering circuit to issue signals to stop the operation of the stepping-down circuit at the end of the turn-off time of the voltage-driven switching element corresponding to the sum of the turn-off delay time and fall time, it is possible to reduce the di/dt and the surge voltage resulting therefrom, limiting the voltage stepping period for the reverse-bias voltage to the fall time of the flowing current in the voltage-driven switching element, enabling damage to the voltage-driven switching element caused by the surge voltage to be avoided, any increase in the speed of the turn-off operation, and to obtain functions to avoid the extension of the turn-off delay time associated with the decrease of the reverse-bias voltage, and adverse effects on the safe operation region.

In addition, because the reverse-bias control circuit has the following configuration, it is possible to obtain functions to produce a reverse-bias control circuit on a single chip and reduce its size. The reverse-bias control circuit is constructed with a voltage stepping-down circuit and a recovering circuit. The voltage stepping-down circuit, in turn, consists of series circuit connecting a transistor, a Zener diode and a reverse-blocking diode, and of a turn-off delay setting timer, comprised of a series body of a resistance and a capacitor. The recovering circuit consists of a capacitor, which is connected parallel to the capacitor of said voltage stepping-down section, and a turn-off setting timer which is a series body of a resistance and a capacitor, between which the base of said transistor is connected.

Furthermore, if the circuit is constructed so that reverse blocking diodes are connected in a series on the emitter side of the transistor in a direction such that they block a forward-bias current, the operating voltages on the timers setting the turn-off delay time and the turn-off time, using the voltage between the base and the emitter of the transistor as the threshold value, can be raised as much as the voltage corresponding to the forward voltage drop in the reverse-blocking diodes, making it possible to obtain a function that will prevent maloperations in the reverse-bias control circuit since the base to emitter voltage in the transistor is low.

Moreover, if the reverse-bias control circuit structured as described above is constructed so that the circuit is mounted in the vicinity of a voltage-driven switching element made in a single chip and modularised to form a wire-bonded semiconductor device, the reverse-bias control circuit can be integrated with the voltage-driven switching element while still permitting size reduction of the drive circuit, and allowing the reduction of the wiring inductance and the prevention of maloperations in the reverse-bias control circuit resulting from a surge voltage.

Embodiments of the invention will now be explained with reference to the accompanying drawings, in which:
Figure 1 is a circuit diagram showing as an example a case in which the reverse-bias control circuit according to an embodiment of the present invention is applied to an IGBT;
Figure 2 is a time chart showing the operation of the reverse-bias control circuit in the embodiment of Figure 1;
Figure 3 is a circuit diagram of the reverse-bias control circuit according to a second embodiment of the present invention;
Figure 4 is a simplified plan view of a semiconductor device equipped with the reverse-bias control circuit according to a third embodiment of the present invention;
Figure 5 is a circuit diagram of a conventional switching circuit graphically showing a voltage-driven switching element taking an IGBT as an example; and
Figure 6 is a time chart showing a turn-off operation in a conventional switching circuit.

The present invention will now be explained with reference to the embodiments shown in the drawings.

Figure 1 is a circuit diagram of a reverse-bias control circuit according to the present invention where the circuit is applied to an IGBT, and Figure 2 is a time chart showing the operation of the reverse-bias control circuit. In the Figures, the reverse-bias control circuit is connected parallel to gate G and the emitter E in the IGBT 1 as a voltage-driven switching element to which the bias voltage V_{GE} from the drive circuit 2 is applied, and consists of the voltage-stepping circuit 11 and the recovering circuit 21. In the Figure, the voltage-stepping circuit 11 comprises a series circuit of the Zener diode 14 and the reverse-blocking diode 15 connected in series in the direction in which the current flows in the NPN transistor 13, while its collector side is set in the opposite direction, a voltage stepping-down section 12 with the emitter of the transistor 13 connected on the gate G side of the IGBT 1, the capacitor 17 connected between the base and emitter of the transistor 13, and a series circuit of the resistance 18 and the reverse-blocking diode 19 connected in series on the base side of the transistor. Moreover, it includes a timer 16 setting the turn-off delay time connected parallel to the voltage stepping-down section 12.

The recovering circuit 21 is comprised of an NPN transistor 22 connected in parallel between the emitter and the base of the transistor 13, and the timer 26 to set the turn-off delay timer receiving the bias voltage V_{GE} at both ends, with which the middle point between the capacitor 24 and the resistance 25 is connected to the transistor 22. The reverse blocking diode 19 and the resistance 18 in the turn-off delay setting timer 16 serves also as a path for the collector current in the transistor 22 on the recovering circuit 21 side, by which the circuitry is simplified, and the reverse-bias control circuit is constructed with a transistor, diode and CR timer, thus easily making possible a single-chip construction and reduction of the size of the reverse-bias control circuit.

In the IGBT, which has the reverse-bias control circuit constructed as described above, the turn-off delay setting timer 16 has time constants that are set so that initially the charge voltage in the capacitor 17 reaches the voltage V_{BD} (threshold value) between the base and the emitter of the transistor 13 with as much delay as the turn-off delay time, t_{d}, of the IGBT shown in Figure 2. The turn-off setting timer 26 has its time constants initially set so that the charge voltage in the capacitor 24 reaches the voltage V_{BF} (threshold value) between the base and the emitter of the transistor 22 with as much delay as the turn-off time, t_{OFF}, of the IGBT. When the bias voltage +V_{GE} from the drive circuit 2 changes from the forward-bias voltage +V_{GE} to the reverse-bias voltage -V_{GE} under this condition as shown in Figure 2, the capacitor 17 is charged by the reverse-bias voltage via the reverse-blocking diode 19 and the resistance 18; the reverse-bias voltage -V_{GE} is applied between the gate and the emitter in the IGBT until the charge voltage reaches the threshold value V_{BD} in the transistor 13, that is, the time corresponding to the turn-off delay time, t_{d}, in the IGBT; immediately thereafter the transistor 13 is turned on, the voltage stepping-down section 12 is activated, and the reverse-bias voltage applied between the gate and the emitter in the IGBT is decreased to the predetermined Zener voltage of the Zener diode 14.

When the bias voltage V_{GE} changes from a forward-bias voltage to a reverse-bias voltage, the turn-off setting timer 26 starts the operation, while the transistor 22 turns on with as much delay as the time it takes the charging voltage at the capacitor 24 to reach the transistor's threshold value V_{BF}, that is the time corresponding to the turn-off time, t_{off}, of the IGBT, to discharge the charge stored at the capacitor 17. Therefore, the transistor 13 goes into a turn-off state, and the voltage stepping-down circuit 11 stops decreasing the voltage, whereas the IGBT maintains its turn-off state until the reverse-bias voltage -V_{GE} is applied again, and the forward-bias voltage is applied across the gate and the emitter to turn the IGBT on.

In the reverse-bias control circuit described above, because the decrease in the voltage is limited to the duration of the fall time, t_{f}, in the collector current, I_{c}, of the IGBT as shown in Figure 2, the rate of change, dt/dt, of the collector current is suppressed without affecting the turn-off delay time, t_{d}, and the surge voltage, V_{SG}, which is generated in superposition with the collector-to-emitter voltage, V_{GE}, in the IGBT can be reduced. Furthermore, it can be easily inferred from the explanation of the foregoing embodiment that the reverse-bias control circuit according to this embodiment provides an equivalent effect when it is applied to a power MOSFET.

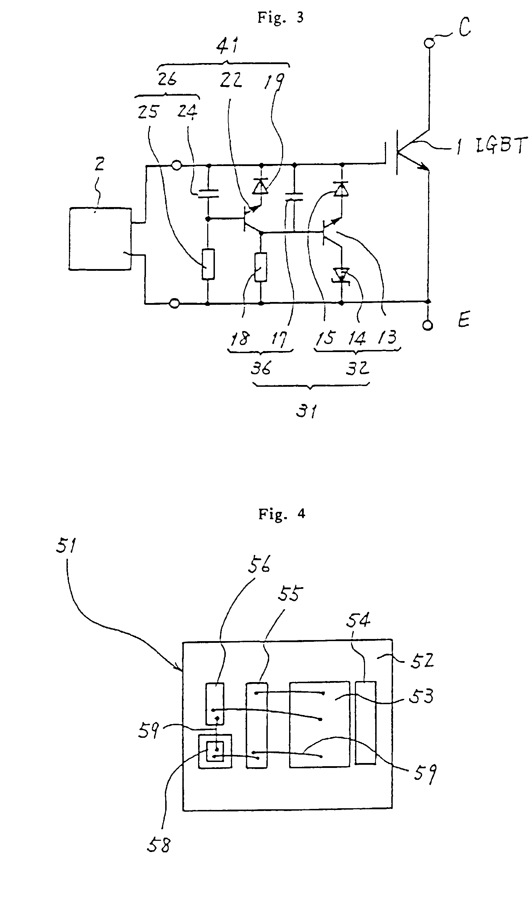

Figure 3 is a circuit diagram of a second reverse-bias control circuit of the present invention, which differs from the first embodiment described in that, in the voltage stepping-down section 32 of the voltage stepping-down circuit 31, the reverse-blocking diode 15 is connected to the emitter side of the transistor 13, and the turn-off delay setting timer 36 is constructed with resistance 18 and the capacitor 17, and is so structured that the reverse-blocking diode 19 is connected to the emitter side of the transistor 22 in the recovering circuit 41. The voltage between the base and the emitter, which is a threshold value for the actions of the transistors 13 and 22, is normally as low as 0.8V, which means that there is a possibility of the so-called (single transistor) noise maloperation; however, by connecting the reverse blocking diodes 15 and 19 to the emitter side of both transistors, the threshold values V_{BD} and V_{BF} can be raised as much as the voltage corresponding to the forward direction drop of the reverse blocking diodes to prevent any maloperation. Therefore, a voltage-driven switching element equipped with a reverse-bias control circuit with high operational reliability can be obtained by simply shifting the connection position of the reverse element diode. In addition, the reverse element diode functions to block a current flowing into the reverse-bias control circuit when the IGBT is biassed in the forward direction between the gate and the emitter.

Figure 4 is a simplified plan view of a semiconductor device equipped with the reverse-bias control circuit according to another embodiment of the present invention, wherein the voltage-driven switching element module which has a voltage-driven switching element chip 53, a collector terminal 54, an emitter terminal 55, and a gate terminal 56 mounted on the substrate 52 is disposed with the reverse-bias control circuit chip 58 made in a single chip to form a semiconductor device with a reverse-bias control circuit 51 with the above components electroconductively connected with each other by the bonding wire 59. In the semiconductor device 51 thus structured, advantages can be obtained including that the wiring inductance can be reduced without preventing the reduction of the size of the drive circuit. Moreover, maloperations due to a surge voltage can be avoided in the reverse-bias control circuit, by integrating the reverse-bias control circuit with the voltage-driven switching element.

In the present invention as described above, the reverse-bias control circuit is equipped with a voltage stepping-down circuit which operates in a time delay corresponding to the delay in turning off the voltage-driven switching element upon receiving the reverse-bias voltage to decrease the reverse-bias voltage down to the predetermined level during the time corresponding to the fall time of the flowing current, and a recovering circuit to issue signals to stop the operation of the stepping-down circuit at the end of the turn-off time of the voltage-driven switching element corresponding to the sum of the turn-off delay time and the fall time. As a result, it is possible to reduce the di/dt and the surge voltage caused there from limiting the voltage decreasing period for the reverse-bias voltage to the fall time of the flowing current in the voltage-driven switching element, making it possible to prevent breakdown failures caused from the surge voltage exceeding the withstand voltage of the voltage-driven switching element, and to prevent the reverse-bias safe operation region from becoming smaller as a result of extended turn-off delay time caused by the reduction of the reverse-bias voltage and increased loss generation associated therewith. Therefore, it is possible to provide a voltage-driven switching element that can increase the speed at which the transistor is turned off while maintaining the reliability relative to the element withstand voltage and the safe operation region.

In addition, because the reverse-bias control circuit has the following configuration, it is possible to obtain functions to produce a reverse-bias control circuit on a single chip and reduce its size. The reverse-bias control circuit is constructed with a voltage stepping-down circuit an a recovering circuit. The voltage stepping-down circuit, in turn, consists of series circuit connecting a transistor, a Zener diode and a reverse-blocking diode, and of a turn-off delay setting timer, which is composed of a resistance and a capacitor in series. The recovering circuit consists of a capacitor, which is connected parallel to the capacitor of said voltage stepping-down section, and a turn-off setting timer which is a resistance and a capacitor connected in series, and between which the base of said transistor is connected.

Furthermore, if the circuit is constructed in such a way that reverse blocking diodes are connected in series on the emitter side of the transistor in a direction that blocks a forward-bias current, the operating voltages on timers setting the turn-off delay time and the turn-off time, using the voltage between the base and the emitter of the transistor as the threshold value, can be raised as much as the voltage corresponding to the forward voltage drop in the reverse-blocking diodes, making it possible to prevent maloperation in the reverse-bias control circuit because the base to emitter voltage is low in the transistor, thus it is possible to provide a voltage-driven switching element equipped with a reverse-bias control circuit with fewer maloperations and high reliability.

Furthermore, if the reverse-bias control circuit is constructed in such a way that the circuit is mounted in the vicinity of a voltage-driven switching element made in a single chip and modularised to form a wire-bonded semiconductor device, the reverse-bias control circuit can be integrated with the voltage-driven switching element without impairing size reduction in the drive circuit, thereby enabling the reduction of wiring inductance to obtain a function to prevent maloperation due to a surge voltage in the reverse-bias control circuit.

## Claims

1. A reverse-bias control circuit for a voltage-driven switching element (1) which turns on upon receiving a forward-bias voltage across its gate (G) and emitter (E) or across the gate and source, and turns off on a reverse-bias voltage, wherein the circuit is equipped with a voltage stepping-down circuit (11) which operates after a time delay corresponding to the delay in turning off said voltage-driven switching element (1) upon receiving the reverse-bias voltage, and a recovering circuit (21) that issues signals to stop the operation of said stepping-down circuit (11) at the end of the turn-off time (t_{off}) of said voltage-driven switching element (1) corresponding to the sum of said turn-off delay time (t_{d}) and the fall time (t_{f}), characterised by the fact that the voltage stepping-down circuit (11) consists of a voltage stepping-down section (12) and a turn-off delay setting timer (16), wherein the stepping-down section (12) consists of a series circuit with a first transistor (13), a Zener diode (14), and a first reverse blocking diode (15) in which the emitter of the first transistor (13) is connected to the gate (G) of the voltage-driven switching element (1) and both ends of said series circuit receive the reverse-bias voltage (V_{GE}), the turn-off delay setting timer (16) consists of a first resistance (18) and a first capacitor (17) connected in series with each other and in parallel with the voltage stepping-down section (12), and the base of said first transistor (13) is connected to the turn-off delay setting timer (16) at a point between the first resistance (18) and the first capacitor (17), and wherein the recovering circuit (21) consists of a second transistor (22) and a turn-off setting timer (26), the second transistor (22) forming a series circuit with said first resistance (18) and a second reverse blocking diode (19) and being connected in parallel to the first capacitor (17), with its emitter connected to the gate (G) of the voltage-driven switching element (1), and the turn-off setting timer (26) consisting of a second resistance (25) and a second capacitor (24) in series connection, between which the base of said second transistor (22) is connected, the arrangement being such that the reverse-bias voltage (V_{GE}) is applied across the ends of the turn-off setting timer (26).

2. A reverse-bias control circuit for the voltage-driven switching element (1), as claimed in Claim 1, wherein a respective one of the first and second reverse blocking diodes (15, 19) is connected in series with the emitter side of the first and second transistors (13, 22) arranged in a direction so that it blocks a forward-bias current.

3. A reverse-bias control circuit for a voltage-driven switching element (1), as claimed in Claim 1 or Claim 2, characterised in that the reverse-bias control circuit (58) is mounted in the vicinity of the voltage-driven switching element (53) formed as a single chip, modularised, and formed as semiconductor devices (53, 58) wire-bonded to each other.

## Patentansprüche

1. Steuerschaltung mit inverser Vorspannung für ein spannungsgesteuertes Schaltelement (1), das sich auf den Empfang einer Durchlaßvorspannung über sein Gate (G) und Emitter (E) oder über das Gate und Source hin einschaltet, und auf eine Sperrvorspannung hin ausschaltet, wobei die Schaltung mit einer Spannungsherabsetzungsschaltung (11) ausgestattet ist, die nach einer Zeitverzögerung arbeitet, die der Verzögerung beim Abschalten des spannungsgesteuerten Schaltelements (1) auf den Empfang der Sperrvorspannung hin entspricht, und einer Wiederherstellungsschaltung (21), die Signale abgibt, um den Betrieb der Herabsetzungsschaltung (11) am Ende der Ausschaltzeit (t_{OFF}) des spannungsgesteuerten Schaltelements (1) zu beenden, die der Summe der Ausschaltverzögerungszeit (t_{d}) und der Abfallzeit (t_{f}) entspricht, dadurch gekennzeichnet, daß die Spannungsherabsetzungsschaltung (11) aus einem Spannungsherabsetzungsabschnitt (12) und einem Ausschaltverzögerungseinstellzeitgeber (16) besteht, wobei der Herabsetzungsabschnitt (12) aus einer Reihenschaltung mit einem ersten Transistor (13), einer Zenerdiode (14), und einer ersten Rückwärtssperrdiode (15) besteht, in dem der Emitter des ersten Transistors (13) mit dem Gate (G) des spannungsgesteuerten Schaltelements (1) verbunden ist, und beide Enden der Reihenschaltung die Sperrvorspannung (U_{GE}) empfangen, der Ausschaltverzögerungseinstellzeitgeber (16) aus einem ersten Widerstand (18) und einem ersten Kondensator (17) besteht, die in Reihe miteinander und parallel zu dem Spannungsherabsetzungsabschnitt (12) geschaltet sind, und die Basis des ersten Transistors (13) mit dem Ausschaltverzögerungseinstellzeitgeber (16) an einer Stelle zwischen dem ersten Widerstand (18) und dem ersten Kondensator (17) verbunden ist, und wobei die Wiederherstellungsschaltung (21) aus einem zweiten Transistor (22) und einer Ausschalteinstellzeitgeber (26) besteht, wobei der zweite Transistor (22) eine Reihenschaltung mit dem ersten Widerstand (18) und einer zweiten Rückwärtssperrdiode (19) bildet und parallel zu dem ersten Kondensator (17) geschaltet ist, wobei sein Emitter mit dem Gate (G) des spannungsgesteuerten Schaltelements (1) verbunden ist, und der Ausschalteinstellzeitgeber (26) aus einem zweiten Widerstand (25) und einem zweiten Kondensator (24) in Reihenschaltung besteht, zwischen denen die Basis des zweiten Transistors (22) angeschlossen ist, wobei die Anordnung so gestaltet ist, daß die Sperrvorspannung (U_{GE}) über die Enden des Ausschalteinstellzeitgebers (26) angelegt wird.

2. Steuerschaltung mit inverser Vorspannung für das spannungsgesteuerte Schaltelement (1) nach Anspruch 1, wobei eine jeweilige der ersten und zweiten Rückwärtssperrdioden (15, 19) in Reihe mit der Emitterseite der ersten und zweiten Transistoren (13, 22) geschaltet ist, angeordnet in einen Richtung, so daß sie einen Durchlaßvorspannungsstrom sperrt.

3. Steuerschaltung mit inverser Vorspannung für ein spannungsgesteuertes Schaltelement (1) nach Anspruch 1 oder Anspruch 2, dadurch gekennzeichnet, daß die Steuerschaltung mit inverser Vorspannung (58) in der Nähe des spannungsgesteuerten Schaltelements (53) angebracht ist, das als ein einziger Chip ausgebildet, modularisiert, und als Halbleitervorrichtungen (53, 58) ausgebildet ist, die miteinander drahtverbunden sind.

## Revendications

1. Circuit de commande d'inversion de polarisation pour un élément de commutation (1) commandé en tension qui devient passant en recevant une tension de polarisation directe à sa grille (G) et son émetteur (E) ou à la grille et la source, et devient bloquant en cas de tension de polarisation inverse, dans lequel le circuit est équipé d'un circuit (11) d'abaissement de tension qui intervient après un délai correspondant au retard au blocage dudit élément de commutation (1) commandé en tension au moment de la réception de la tension de polarisation inverse, et un circuit de rétablissement (21) qui émet des signaux pour arrêter le fonctionnement dudit circuit d'abaissement (11) à la fin du temps de blocage (t_{off}) dudit élément de commutation (1) commandé en tension correspondant à la somme dudit temps de retard (t_{d}) et du temps de descente (t_{f}), caractérisé par le fait que le circuit (11) d'abaissement de tension est constitué par une section (12) d'abaissement de tension et une minuterie (16) de réglage de retard au blocage, dans lequel la section d'abaissement (12) est constituée par un circuit série avec un premier transistor (13), une diode Zener (14) et une première diode de blocage en inverse (15), dans lequel l'émetteur du premier transistor (13) est relié à la grille (G) de l'élément de commutation (1) commandé en tension et les deux extrémités dudit circuit série reçoivent la tension de polarisation inverse (V_{GE}), la minuterie (16) de réglage de temps de blocage est constituée par une première résistance (18) et un premier condensateur (17) montés en série l'un avec l'autre et en parallèle avec la section (12) d'abaissement de tension, et la base dudit premier transistor (13) est reliée à la minuterie (16) de réglage de retard au blocage en un point situé entre la première résistance (18) et le premier condensateur (17), et dans lequel le circuit de rétablissement (21) est constitué par un second transistor (22) et une minuterie (26) de réglage de temps de blocage, le second transistor (22) formant un circuit série avec ladite première résistance (18) et une seconde diode de blocage en inverse (19) et étant monté en parallèle avec le premier condensateur (17), son émetteur étant relié à la grille (G) de l'élément de commutation (1) commandé en tension, et la minuterie (26) de réglage de temps de blocage étant constituée par une seconde résistance (25) et un second condensateur (24) montés en série, entre lesquels est connectée la base dudit second transistor (22), le montage étant tel que la tension de polarisation inverse (V_{GE}) est appliquée aux extrémités de la minuterie (26) de réglage de temps de blocage.

2. Circuit de commande d'inversion de polarisation pour un élément de commutation (1) commandé en tension, selon la revendication 1, dans lequel une diode respective parmi les première et seconde diodes (15, 19) de blocage en inverse est montée en série avec le côté émetteur des premier et second transistors (13, 22) et disposée dans une direction telle qu'elle bloque un courant de polarisation directe.

3. Circuit de commande d'inversion de polarisation pour un élément de commutation (1) commandé en tension, selon la revendication 1 ou la revendication 2, caractérisé en ce que le circuit (58) de commande d'inversion de polarisation est monté au voisinage de l'élément de commutation (53) commandé en tension qui se présente sous la forme d'une seule puce, modularisée, et sous la forme de dispositifs (53, 58) à semiconducteurs connectées par fils l'un à l'autre.
